# EUROPÄISCHE PATENTSCHRIFT

(11) **EP 0 524 964 B1**
(45) Veröffentlichungstag und Bekanntmachung des Hinweises auf die Patenterteilung: **18.11.1993**
(21) Anmeldenummer: 91906403.0
(22) Anmeldetag: 23.03.1991
(51) Int. Cl.: H05K 7/20

(54) **VERFAHREN ZUR MONTAGE UND ISOLATIONSPRÜFUNG VON ELEKTRONISCHEN LEISTUNGSBAUELEMENTEN AUF KÜHLKÖRPERN**
PROCESS FOR THE ASSEMBLY AND INSULATION-TESTING OF ELECTRONIC POWER COMPONENTS FITTED TO COOLING ELEMENTS
PROCEDE POUR LE MONTAGE ET L'ESSAI D'ISOLEMENT DE COMPOSANTS ELECTRONIQUES DE PUISSANCE SUR DES REFROIDISSEURS

(30) Priorität: 14.04.1990 DE 4012180
(43) Veröffentlichungstag der Anmeldung: 03.02.1993
(73) Patentinhaber: ROBERT BOSCH GMBH, 70442 Stuttgart (DE)
(72) Erfinder: KLINGER, Herbert, D-8500 Nürnberg 60 (DE); THOMAS, Gerhard, D-8510 Fuerth (DE); PETRZIK, Martin, D-8500 Nürnberg 90 (DE)
(86) Internationale Anmeldenummer: DE9100263
(87) Internationale Veröffentlichungsnummer: WO9116809

(56) Entgegenhaltungen:
- DE-A- 3 304 952
- DE-A- 3 331 207
- DE-B- 2 722 142
- US-A- 4 669 028

## Beschreibung

### Stand der Technik

Die Erfindung geht aus von einem Verfahren zur Montage und Isolationsprüfung von elektronischen Leistungsbauelementen in elektrischen Schalt- und Steuergeräten, insbesondere für Kraftfahrzeuge nach der Gattung des Patentanspruchs 1.

Aus der DE-OS 33 31 207 ist bereits bekannt, die elektronischen Leistungsbauelemente an einem Kühlkörper über eine wärmeleitende Isolierfolie mittels eines Fixierteiles aus Kunststoff zu befestigen und die so vormontierte Baugruppe elektrisch zu prüfen, wobei zur Isolationsprüfung zwischen Kühlkörper und Leistungsbauelemente Hochspannung angelegt wird. Danach wird die vormontierte Baugruppe auf der Leiterplatte befestigt, wobei die Anschlußpins der Leistungsbauelemente in aufwendiger und mühseliger Weise in die ihnen zugeordneten Löcher der Leiterplatte eingeführt werden müssen. Danach werden die Leistungsbauelemente mit weiteren elektronischen Bauelementen auf der Leiterplatte durch Löten verschaltet. Bei derartigen Schalt- und Steuergeräten für Kraftfahrzeuge bilden in der Regel die Bauelemente auf der Leiterplatte einen Logikteil und die Leistungsauelemente bilden dazu die Endstufen in Form von Leistungs-transistoren.

Das vorgenannte Verfahren zur Montage und Isolationsprüfung zwischen Kühlkötper und Leistungsbauelementen soll sicherstellen, daß empfindliche Bauteile wie z.B. Rechner auf der Leiterplatte durch Hochspannung nicht zerstört werden. Die bekannte Losung hat jedoch den Nachteil, daß insbesondere bei verbogenen Anschlußpins das Einsetzen der vormontierten Kühlkörper-Leistungsbauelemente-Baugruppe in die Leiterplatte erhebliche Probleme mit sich bringt, so daß eine maschinelle Montage dabei nicht möglich ist.

Mit der erfindungsgemäßen Losung wird angestrebt, die Leistungsbauelemente mit ihren Anschlußpins einzeln in die Leiterplatte einsetzen und gemeinsam kontaktieren zu können, ohne bei der Isolationsprüfung die spannungsempfindlichen Bauelemente zu gefährden.

### Vorteile der Erfindung

Die erfindungsgemäße Verfahrensfolge für den Zusammenbau und die Isolationsprüfung des elektronischen Schalt- und Steuergerätes hat den Vorteil, daß der Kühlkörper bei der Isolationsprüfung potentialfrei ist, so daß die zwischen ihm und den mit der Leiterplatte verbundenen Leistungsbauelementen angelegte Hochspannung nicht an den übrigen, spannungsempfindlichen Bauteilen auf der Leiterplatte wirksam werden kann. Ein weiterer Vorteil besteht darin, daß die Leistungsbauelemente nunmehr einzeln und daher wesentlich problemloser und daher auch maschinell in die entsprechenden Löcher der Leiterplatte eingesetzt werden können.

Durch die in den Unteransprüchen aufgeführten Maßnahmen ergeben sich vorteilhafte Weiterbildungen und Verbesserungen der im Patentanspruch 1 angegebenen Merkmale. Alle Komponenten und Bauteile können nunmehr einzeln und direkt von oben mit Hilfe von Einführhilfen, Noppen und Fixierstiften leicht in die Leiterplatte eingesetzt und bei defekten Bauelementen können diese leicht demontiert und ausgewechselt werden. Durch die Einführhilfen ergibt sich eine einfache, kostengünstige und schnelle Montage, da nur noch die Anschlußpins von jeweils einem Bauteil gefügt werden mussen. Bei verbogenen Anschlußpins kann eine leichte Korrektur von Hand erfolgen. Damit ergibt sich eine höhere Fertigungssicherheit bei gleichzeitiger Zeit- und Kostenersparnis.

Da der Kühlkörper erst nach der Hochspannungsprüfung elektrisch mit der Schaltungsmasse verbunden wird, können die Leistungsbauelemente mit Hochspannung geprüft werden, ohne daß die restlichen Bauteile auf der Leiterplatte dabei elektrisch belastet werden. In einfachster Weise wird dabei nach der Isolationsprüfung eine mit dem Masseanschluß verbundene Leiterbahn der Leiterplatte als sogenannte Schaltungsmasse über mindestens eine weitere Nietstelle mit dem Kühlkörper und somit auch mit dem Gehause oder Frontplatte elektrisch leitend verbunden. Eine besonders vorteilhafte Montagehilfe für das Einsetzen der Leistungsbauelemente in die Leiterplatte läßt sich dadurch erreichen, daß die Leistungsbauelemente in einem am Kühlkörper und Leiterplatte aufgesteckten Kunststoffrahmen einzeln eingesetzt werden und sich dabei mit ihren Anschlußpins durch konisch erweiterte Löcher des Kunststoffrahmens selbst in die ihnen zugeordneten Löcher der Leiterplatte einfädeln.

### Zeichnung

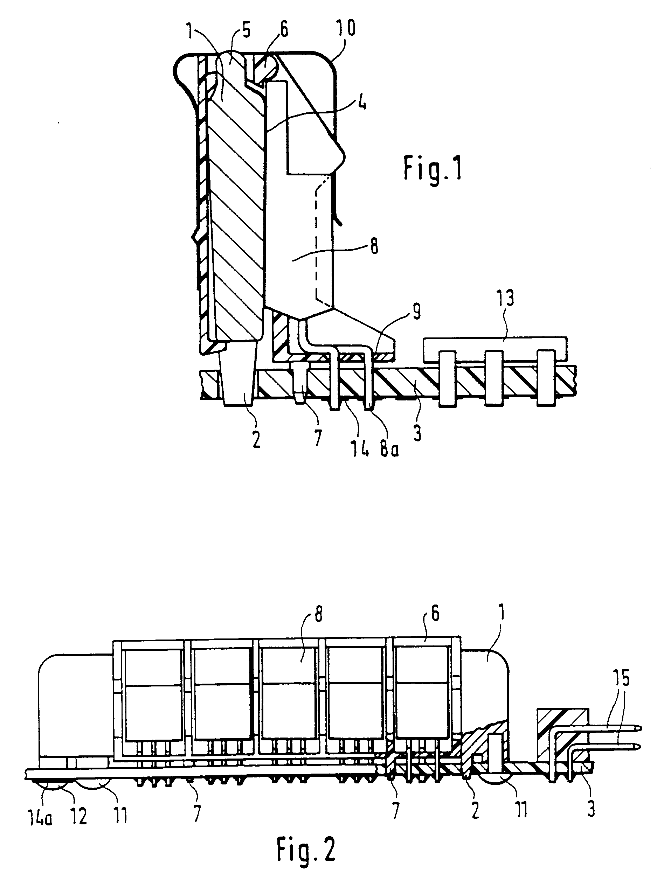

Ein Ausführungsbeispiel der Erfindung ist in der Zeichnung dargestellt und in der nachfolgenden Beschreibung näher erläutert. Es zeigt Figur 1 eine vormontierte Baugruppe für ein Schalt- und Steuergerät aus Kühlplatte, Leistungsbauelement und Leiterplatte vor der Isolationsprüfung in vergrößerter Darstellung im Querschnitt und Figur 2 zeigt die Vorderansicht der vormontierten Baugruppe mit der zusätzlichen Masseverbindung des Kühlkörpers nach der Isolationsprüfung.

### Beschreibung des Ausführungsbeispieles

Zur Herstellung eines Schalt- und Steuergerätes für Kraftfahrzeuge wird zunächst ein Kühlkörper l aus Aluminiumspritzguß mit Führungszapfen 2 auf eine Leiterplatte 3 aufgesetzt, die zuvor mit weiteren Bauelementen 13, insbesondere Logikbausteinen bestückt wurde. An Befestigungsbohrungen der Leiterplatte 3 wird der Kühlkörper 1 durch Niete 11 befestigt, wobei die Leiterplatte 3 in diesen Bereichen keine Leiterbahnen aufweist. Eine wärmeleitende Isolierfolie 4 wird sodann auf einen Führungsvorsprung 5 des Kühlkörpers 1 aufgelegt und mit der Vorderseite des Kühlkörpers 1 verklebt. Auf den Kühlkörper 1 wird nunmehr ein Kunststoffrahmen 6 aufgeschoben, der mit Führungszapfen 7 in der Leiterplatte 3 fixiert wird. Danach werden die elektronischen Leistungsbauelemente 8 in den Kunststoffrahmen 6 eingelegt und ihre Anschlußpins 8a werden dabei durch konisch erweiterte Löcher 9 im Boden des Kunststoffrahmens 6 in die ihnen zugeordneten Löcher der Leiterplatte 3 eingefädelt. Eine Klemmfeder 10 wird anschließend auf jedes der elektronischen Leistungsbauelemente 8 und den Kühlkörper 1 aufgeschoben, so daß diese über die Isolierstoffolie 4 flächig einander anliegen. Über die auf der Unterseite der Leiterplatte 3 liegenden Leiterbahnen 14 werden nunmehr die Anschlüsse der elektronischen Bauelemente 8 und 13 sowie Anschlußteile 15 des Schalt- und Steuergerätes durch Löten miteinander verschaltet.

Die so vorgefertigte Baugruppe wird nun zur Prüfung der Isolation zwischen Kühlkörper 1 und Leistungsbauelementen 8 an Hochspannung angelegt, wobei diese Hochspannung einerseits an den noch potentialfreien Kühlkörper 1 und an die verschiedenen Anschlußpins 8a der Leistungsbauelemente 8 angeschlossen wird. Durch die potentialfreie Befestigung des Kühlkörpers 1 an der Leiterplatte 3 wird sichergestellt, daß die angelegte Hochspannung dabei nicht die spannungsempfindlichen Bauelemente 13, wie beispielsweise Mikroprozessoren oder Logikbaugruppen und dgl. gefährdet. Erst nach dieser Prüfung wird schließlich im Bereich einer Leiterbahn 14a der Leiterplatte 3, die als Schaltungsmasse mit einem Masseanschluß der Anschlußteile 15 verbunden ist, durch einen weiteren Niet 12 der Kühlkorper 1 an der Leiterplatte 3 befestigt und dabei die Schaltungsmasse mit dem Kühlkörper 1 elektrisch leitend verbunden. Selbstverständlich können hierfür auch weitere Nietstellen 12 vorgesehen werden, die an weiteren Stellen die Leiterbahn 14a mit dem Kühlkörper 1 verbinden. Schließlich wird die nach Figur 2 vormontierte Baugruppe in ein Gehäuse des nicht dargestellten Schalt- und Steuergerätes eingesetzt und dieses Gehäuse mit einem die Anschlußteile 15 einfassenden Deckel verschlossen.

## Patentansprüche

1. Verfahren zur Montage und Isolationsprüfung von elekronischen Leistungsbauelementen (8) in elektrischen Schalt- und Steuergeräten, insbesondere für Kraftfahrzeuge, die wärmeleitend und elektrisch isoliert an einem Kühlkörper (1) befestigt sind, der fest auf einer Leiterplatte (3) sitzt, auf der die Leistungsbauelemente (8) und weitere elektrische Bauelemente (13) über Leiterbahnen (14) durch Löten miteinander sowie mit Anschlußteilen (15) und einer Schaltungsmasse (14a) verschaltet sind, dadurch gekennzeichnet, daß zunächst der Kühlkörper (1) potentialfrei an der Leiterplatte (3) befestigt wird daß nun die Leistungsbauelemente (8) wärmeleitend und elektrisch isoliert am Kühlkörper (1) in die Leiterplatte (3) eingesetzt und die Anschlußpins (8a) der Leistungsbauelemente (8) mit den Leiterbahnen (14) der Leiterplatte (3) verlötet werden, daß danach die Isolation zwischen dem potentialfreien Kühlkörper (1) und den Leistungsbauelementen (8) durch Anlegen einer Hochspannung geprüft wird und daß schließlich der Kühlkörper (1) mit der Schaltungsmasse (14a) elektrisch verbunden wird.

2. Verfahren nach Anspruch 1, dadurch gekennzeichnet, daß eine als Schaltungsmasse mit dem Masseanschluß verbundene Leiterbahn (14a) der Leiterplatte (3) nach der Isolationsprüfung der Leistungsbauelemente (8) über mindestens eine Nietstelle (12) mit Kühlkörper (1) elektrisch leitend verbunden wird.

3. Verfahren nach Anspruch 1 oder 2, dadurch gekennzeichnet, daß die Leistungsbauelemente (8) in einem am Kühlkörper (1) und Leiterplatte (3) aufgesteckten Kunststoffrahmen (6) einzeln eingesetzt und dabei mit ihren Anschlußpins (8a) durch konisch erweiterte Locher (9) des Kunststoffrahmens (6) in die ihnen zugeordneten Löcher der Leiterplatte (3) eingefädelt werden.

4. Verfahren nach Anspruch 3, dadurch gekennzeichnet, daß die Leiterplatte (3) und der darauf mit Führungen (7) aufgesteckte Kunststoffrahmen (6) mit den Leistungsbauelementen (8) maschinell bestückt wird.

## Claims

1. Method for assembling and insulation testing of electronic power components (8) in electrical switching and control apparatuses, especially for motor vehicles, which apparatuses are mounted in a thermally conductive and electrically insulating manner on a heat sink (1) which is firmly seated on a printed-circuit board (3) on which the power components (8) and further electrical components (13) are connected via conductor tracks (14), by soldering to one another, and having connecting parts (15) and a circuit earth (14a), characterised in that, initially, the heat sink (1) is mounted in a floating manner on the printed-circuit board (3), in that the power components (8) are now inserted into the printed-circuit board (3) in a thermally conductive and electrically insulated manner on the heat sink (1), and the connecting pins (8a) of the power components (8) are soldered to the conductor tracks (14) of the printed-circuit board (3), in that, thereafter, the insulation between the floating heat sink (1) and the power components (8) is tested by applying a high voltage, and in that, finally, the heat sink (1) is electrically connected to the circuit earth (14a).

2. Method according to Claim 1, characterised in that a conductor track (14a), which is connected to the earth connection as circuit earth, of the printed-circuit board (3) is electrically conductively connected to the heat sink (1), after the insulation test of the power components (8), via at least one riveted point (12).

3. Method according to Claim 1 or 2, characterised in that the power components (8) are inserted individually in a plastic frame (6) which is plugged onto the heat sink (1) and printed-circuit board (3), and, at the same time, their connecting pins (8a) are threaded through conically expanded holes (9) in the plastic frame (6) into the holes in the printed circuit board (3) allocated to them.

4. Method according to Claim 3, characterised in that the printed-circuit board (3) and the plastic frame (6) which is plugged thereon by means of guides (7) are fitted with the power components (8) by machine.

## Revendications

1. Procédé de montage et de contrôle de l'isolation de composants électroniques de puissance (8) dans des appareils de commutation et de commande électrique, notamment pour des véhicules automobiles, composants qui sont fixés sur un organe de refroidissement (1) en étant isolés électriquement et sur le plan de la conduction thermique, cet organe de refroidissement étant monté solidairement sur une plaque de circuit imprimé (3) portant les composants de puissance (8) et d'autres composants électriques (13) reliés par des chemins conducteurs (14) soudés, et des parties de branchement (15) et une masse de circuit (14a), procédé caractérisé en ce qu'on fixe tout d'abord l'organe de refroidissement (1), sans potentiel sur la plaque de circuit imprimé (3) puis on place les composants de puissance (8) de façon conductrice de chaleur et de manière isolée électriquement sur l'organe de refroidissement (1) dans la plaque conductrice (13) et on soude les broches de branchement (8a) des composants de puissance (8) aux chemins conducteurs (14) de la plaque de circuit imprimé (3), puis on contrôle l'isolation entre l'organe de refroidissement (1) non mis au potentiel et les composants de puissance (8) par application d'une haute tension et enfin on relie électriquement l'organe de refroidissement (1) et la masse (14a) du circuit.

2. Procédé selon la revendication 1, caractérisé en ce qu'après le contrôle d'isolation des composants de puissance (8) on relie un chemin conducteur (14a) de la plaque de circuit imprimé (3) reliée à la borne de masse, et à la masse du circuit par au moins un point de rivetage (12) à l'organe de refroidissement (1) par une liaison électrique.

3. Procédé selon la revendication 1 ou 2, caractérisé en ce que les composants de puissance (8) sont placés séparément dans un châssis de matière plastique (6) lui-même prévu sur l'organe de refroidissement (1) et enfiché dans la plaque de circuit imprimé (3), et on enfile par les broches de branchement (8a) à travers des orifices (9) élargis de manière conique dans le châssis de matière plastique (6), pour l'enfiler dans les perçages associés dans la plaque de circuit imprimé (3).

4. Procédé selon la revendication 3, caractérisé en ce que la plaque de circuit imprimé (3) et le châssis de matière plastique (6) enfiché avec ses guides (7) reçoit les composants de puissance (6) mis en place à la machine.
